(19) Europäisches Patentamt
European Patent Office
Office européen des brevets

(11) **EP 3 588 777 B1**

(12) **EUROPÄISCHE PATENTSCHRIFT**

(45) Veröffentlichungstag und Bekanntmachung des Hinweises auf die Patenterteilung:
**29.09.2021  Patentblatt 2021/39**

(21) Anmeldenummer: **18180699.3**

(22) Anmeldetag: **29.06.2018**

(51) Int Cl.:
*H03K 17/0812* (2006.01)       *H03K 17/16* (2006.01)
*H03K 17/0412* (2006.01)      *H02H 9/00* (2006.01)
*H02M 1/36* (2007.01)

(54) **SCHALTUNGSANORDNUNG ZUR STEUERUNG EINES ELEKTRONISCHEN EINGANGSSCHALTERS**

CIRCUIT ASSEMBLY FOR CONTROLLING AN ELECTRONIC INPUT CIRCUIT

AGENCEMENT DE CIRCUIT DESTINÉ À COMMANDER UN COMMUTATEUR D'ENTRÉE ÉLECTRONIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**01.01.2020  Patentblatt 2020/01**

(73) Patentinhaber: **ZKW Group GmbH**
**3250 Wieselburg (AT)**

(72) Erfinder:
• **Koller, Jan**
  **1120 Wien (AT)**

• **Steindl, Günter**
  **1230 Wien (AT)**

(74) Vertreter: **Patentanwaltskanzlei**
**Matschnig & Forsthuber OG**
**Biberstraße 22**
**Postfach 36**
**1010 Wien (AT)**

(56) Entgegenhaltungen:
**EP-A1- 2 259 422          EP-A1- 2 688 209**
**EP-A2- 2 388 917          WO-A1-2012/087320**
**WO-A1-2012/097866     WO-A1-2015/037441**
**US-A1- 2015 303 917**

## Beschreibung

Die Erfindung bezieht sich auf eine Schaltungsanordnung zur Steuerung eines elektronischen Eingangsschalters, mit welchem eine Last mit hohem kapazitiven Anteil an eine Kraftfahrzeugbatterie schaltbar ist, wobei dem Eingang einer Ansteuerschaltung für den elektronischen Eingangsschalter ein Einschaltsignal zugeführt ist.

Bei Steuergeräten in Kraftfahrzeugen, welche direkt an die Fahrzeugbatterie geschaltet sind, muss nach den gängigen Fahrzeugherstellernormen eine sogenannte Ruhestromanforderung erfüllt werden, welche sich darauf bezieht, die Fahrzeugbatterie möglichst wenig zu belasten, falls das Fahrzeug außer Betrieb ist bzw. die angeschlossene Last ausgeschaltet ist. Im Normalfall werden beispielsweise Schaltwandler, wie Hochsetzsteller (Boost-Konverter) zur Bereitstellung einer Zwischenkreisspannung von der Klemme der Fahrzeugbatterie mit einem sogenannten High-Side-Schalter, d.h. einem Ruhestromschalter, aktiv weggeschaltet. Bei der Klemme handelt es sich meist um den gemäß der Norm DIN 72552 mit "Klemme 30" bezeichneten direkten Pluspol der Fahrzeugbatterie.

Da ein Hochsetzsteller wegen seines Aufbaus und seiner Zwischenkreiskondensatoren im ausgeschalteten Zustand einen Kurzschluss zwischen der Eingangsspannung und der Ausgangsspannung bildet und der Strom ungehindert von dem Eingang zu dem Ausgang fließen und die Zwischenkreiskondensatoren auf die Eingangsspannung aufladen kann, muss man bei den Einschaltströmen nicht nur die Kondensatoren am Eingang des Spannungswandlers berücksichtigen, sondern auch die Kondensatoren am Ausgang. Dies bedeutet, dass beim Einschalten des genannten Ruhestromschalters auf Grund der hohen Kapazitäten der anzuschaltenden Last hohe Einschaltströme auftreten können.

Das erwähnte Problem der Einschaltströme betrifft ganz allgemein Lasten mit einem hohen kapazitiven Anteil. Unter einer "Last mit hohem kapazitiven Anteil" ist im Rahmen der gegenständlichen Erfindungsbeschreibung eine Last zu verstehen, welche auf Grund einer kapazitiven Komponente einen unerwünscht hohen Einschaltstromstoß verursacht, wenn sie direkt an eine Kraftfahrzeugbatterie gelegt wird. Derartige Einschaltstromstöße, deren Werte oft ein Vielfaches des normalen Dauerbetriebsstromes betragen, können im Versorgungsnetzt eines Kraftfahrzeuges unter anderem zu Spannungseinbrüchen führen, welche andere von diesem Netz gespeiste Systeme ungünstig beeinflussen können. Klar ist es, dass sich keine absoluten Werte für den kapazitiven Anteil angeben lassen, da der Einfluss des kapazitiven Anteils beispielsweise von der Höhe der Batteriespannung und von der Empfindlichkeit anderer Systeme des Kraftfahrzeugs auf Spannungseinbrüche abhängt.

US 2015/303917 A1, WO 2012/097866 A1, EP 2 259 422 A1, WO 2012/087320 A1, EP 2 388 917 A2, EP 2 688 209 A1 und WO 2015/037441 A1 können als relevanter Stand der Technik angesehen werden.

Somit ist es eine Aufgabe der Erfindung, die beschriebenen Probleme, die im Zusammenhang von Lasten mit hohem kapazitiven Anteil auftreten können, zu verringern oder zu beheben.

Diese Aufgabe wird mit einer Schaltungsanordnung der eingangs genannten Art gelöst, bei welcher erfindungsgemäß die Ansteuerschaltung für den elektronischen Eingangsschalter dazu eingerichtet ist, bei Erhalt des Einschaltsignals den elektronischen Eingangsschalter zunächst über einen Anlaufzeitraum mit einer Anzahl von Einschaltimpulsen getaktet zu schließen und zu öffnen und anschließend dauernd zu schließen, solange das Einschaltsignal an dem Eingang der Ansteuerschaltung anliegt.

Die Erfindung gibt dem Fachmann eine Möglichkeit in die Hand, auf einfache Weise und ohne die Notwendigkeit, an der anzuschaltenden Last Modifikationen vorzunehmen, den Einschaltstrom so zu beeinflussen, insbesondere langsam ansteigen zu lassen bzw. zu begrenzen, dass es zu keinen unerwünschten Wirkungen auf die von der Kraftfahrzeugbatterie versorgten Systeme kommt.

Bei einer zweckmäßigen Variante der Erfindung ist vorgesehen, dass der elektronische Eingangsschalter einen von einem Bipolartransistor angesteuerten FET-Transistor umfasst, wobei dem Bipolartransistor ein Ausgangssignal der Ansteuerschaltung zugeführt ist.

Eine vorteilhafte Variante sieht vor, dass der Ansteuerschaltung ein mit der Eingangsspannung der Last korreliertes Signal zugeführt ist und die Ansteuerschaltung für den elektronischen Eingangsschalter dazu eingerichtet ist, solange zu schließen und zu öffnen, bis eine Solleingangsspannung der Last erreicht ist.

In anderen Fällen kann es zweckmäßig sein, wenn der Ansteuerschaltung ein mit dem Eingangsstrom der Last korreliertes Signal zugeführt ist und die Ansteuerschaltung für den elektronischen Eingangsschalter dazu eingerichtet ist, solange zu schließen und zu öffnen, bis der Sollbetriebsstrom der Last erreicht ist.

Zum Vermeiden von unerwünschten Verzögerungen beim Anschalten der Last hat es sich erfindungsgemäß erwiesen, wenn die Dauer des ersten der Einschaltimpulse ein Mehrfaches der Dauer der folgenden Einschaltimpulse beträgt.

Die Erfindung entfaltet ihre Vorteile besonders, falls die Last ein Hochsetzsteller ist.

Die Erfindung samt weiteren Vorteilen ist im Folgenden an Hand beispielsweiser Ausführungsformen näher erläutert, die in der Zeichnung veranschaulicht sind. In dieser zeigen

Fig. 1 in einem Prinzipschaltbild eine erste Ausführungsform der Erfindung,
Fig. 2 in einem Diagramm den mit einem Oszilloskop aufgenommenen Verlauf von Eingangsstrom und Eingangsspannung einer Last mit hohem kapazitiven Anteil, nämlich eines Hochsetzstellers, bei Anlegen eines Einschaltsignals an einen elektronischen Eingangsschalter ohne Anwendung der Erfindung, somit nach dem Stand der Technik,

Fig. 3 in einem Diagramm analog zu Fig. 2 den Verlauf von Eingangsstrom und Eingangsspannung einer Last mit hohem kapazitiven Anteil, nämlich eines Hochsetzstellers, bei Anlegen eines Einschaltsignals an einen elektronischen Eingangsschalter mit Anwendung eines vergleichbaren Beispiels zur Erfindung,

Fig. 4 in einem Diagramm analog zu Fig. 2 den Verlauf von Eingangsstrom und Eingangsspannung bei Anlegen eines Einschaltsignals an den elektronischen Eingangsschalter mit Anwendung der Erfindung, wobei die Dauer des ersten der Einschaltimpulse ein Mehrfaches der Dauer der folgenden Einschaltimpulse beträgt,

Fig. 5 in einem Prinzipschaltbild eine weitere Ausführungsform der Erfindung, bei welcher der Ansteuerschaltung ein der Eingangsspannung der Last entsprechendes Signal zugeführt ist, und

Fig. 6 in einem Prinzipschaltbild eine andere Ausführungsform der Erfindung, bei welcher der Ansteuerschaltung ein dem Eingangsstrom der Last entsprechendes Signal zugeführt wird.

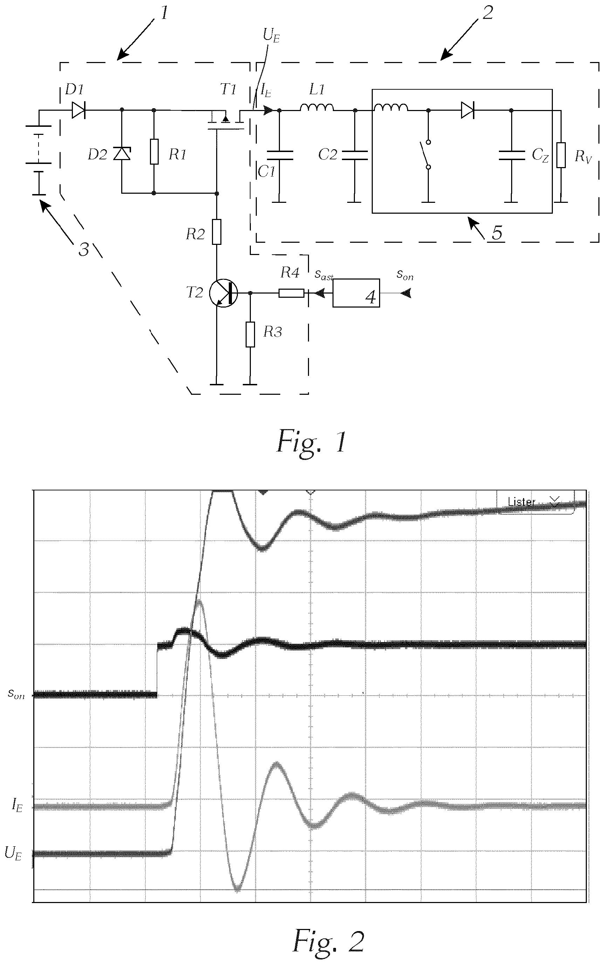

**Fig. 1** zeigt eine erste Ausführungsform der Erfindung in vereinfachter Darstellung. Man erkennt einen elektronischen Eingangsschalter **1,** eine Last **2** mit hohem kapazitiven Anteil, eine Kraftfahrzeugbatterie **3,** an welche die Last 2 geschaltet wird und eine Ansteuerschaltung **4** für den elektronischen Eingangsschalter. Die teilweise in Blöcken dargestellten Elemente der erfindungsgemäßen Ansteuerschaltung und deren Funktionsweise werden nun im Detail beschrieben.

Der Pluspol der Kraftfahrzeugbatterie 3 mit beispielsweise einer Nennspannung von 12 Volt ist über eine Verpolschutzdiode **D1** zu einem Anschluss der Schaltstrecke eines FET-Transistors **T1** geführt, dessen anderer Anschluss mit dem Eingang der Last 2 verbunden ist. Zum Schutz des Gates des Transistors T1 sind in bekannter Art zwischen Source und Gate eine Zenerdiode **D2** und dazu parallel ein Widerstand **R1** vorgesehen. Das Gate des Transistors T1 ist zur Strombegrenzung über einen Widerstand **R2** mit dem Kollektor eines npn-Transistor **T2** verbunden, welcher zur Ansteuerung des Transistors T1 vorgesehen ist und dessen Emitter an Masse liegt. Die Basis des Transistors T2 liegt über einen Widerstand **R3** an Masse und ist zur Strombegrenzung über einen Widerstand **R4** mit dem Ausgang der Ansteuerschaltung 4 verbunden, welche ein Ansteuersignal $s_{ast}$ an den Eingangsschalter 1 liefert.

Was die Last 2 mit hohem kapazitiven Anteil betrifft, so besteht diese im vorliegenden Fall aus einem Hochsetzsteller **5,** der hier nur symbolisch dargestellt ist, und der einen Verbraucher speist, welcher hier symbolisch als Widerstand $R_v$ eingezeichnet ist. Die Last 2 beinhaltet bei diesem Beispiel noch ein Π-Filter, bestehend aus einer Längsinduktivität $L_1$ und zwei Kondensatoren $C_1$ und $C_2$. Der erwähnte Hochsetzsteller 5 enthält ausgangsseitig einen Zwischenkreiskondensator $C_z$. Dem Eingang der Ansteuerschaltung 4 wird ein Einschaltsignal $s_{on}$ zugeführt.

Um den nachteiligen Einschaltstromstoß zu vermeiden, ist nun im Sinne der Erfindung vorgesehen, dass die Ansteuerschaltung 4 dazu eingerichtet ist, bei Erhalt des Einschaltsignals $s_{on}$ ein Ansteuersignal $s_{ast}$ an den elektronischen Eingangsschalter 1 zu liefern, welches diesen zunächst über einen Anlaufzeitraum $t_{an}$ mit einer Anzahl n von Einschaltimpulsen getaktet schließt und öffnet und anschließend dauernd schließt (EIN-Signal) solange das Einschaltsignal $s_{on}$ an dem Eingang der Ansteuerschaltung 4 anliegt.

Nun wird zunächst auf **Fig. 2** Bezug genommen, welche in einem Diagramm den mit einem Oszilloskop aufgenommenen Verlauf von Eingangsstrom $I_E$ und Eingangsspannung $U_E$ einer Last mit hohem kapazitiven Anteil, nämlich eines Hochsetzstellers, bei Anlegen eines Einschaltsignals $s_{on}$ an einen elektronischen Eingangsschalter ohne Anwendung der Erfindung, somit nach dem Stand der Technik, zeigt. Der Zeitmaßstab in dem Diagramm beträgt 100 μs/Einheit, der Strommaßstab für $I_E$ 10 A/Einheit, der Spannungsmaßstab für $s_{on}$ 5V/Einheit und für $U_E$ 2 V/Einheit.

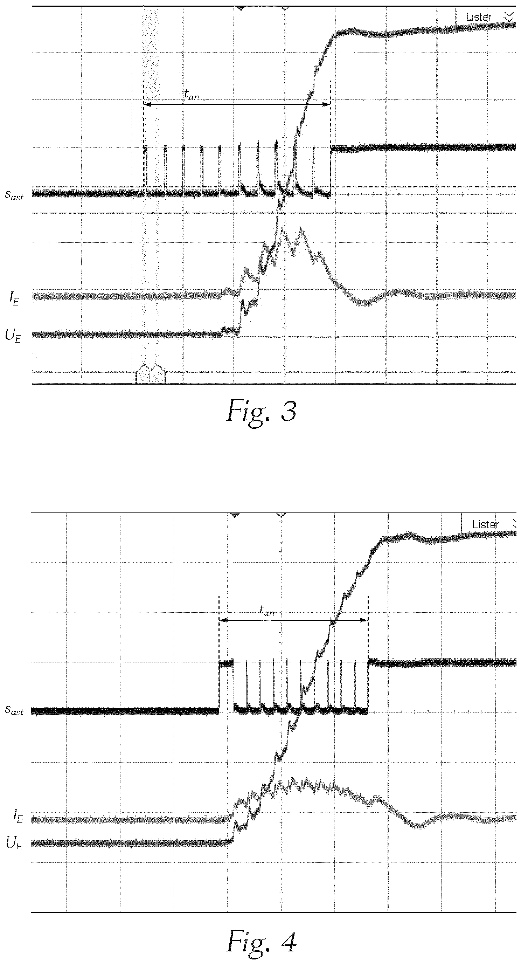

Man erkennt, dass mit geringer Verzögerung nach Auftreten des Einschaltsignals $s_{on}$ der Eingangsstrom $I_E$ auf einen Wert von ca. 40 A springt um dann nach einem Einschwingvorgang innerhalb ca. 500 μs auf einen sehr niedrigen Wert abzufallen. In dieser Zeit steigt die Eingangsspannung $U_E$ mit einem gewissen Überschwingen auf den Wert der Solleingangsspannung $U_{soll}$ von ca. 13 V. Der maximal auftretende Eingangsstrom $I_{max}$ ergibt sich vor allem, nämlich bei Vernachlässigung ohmscher Anteile, über die Größe der in der Last aufzuladenden Kapazitäten C und der Eingangsspannung $U_{soll}$ als

$$I_{max} = C.U_{soll}/t_{ein}$$

wobei $t_{ein}$ jene Zeitdauer ist, die für den Aufladevorgang benötigt wird und für welche in erster Linie die Serieninduktivität der Beschaltung bzw. der Last verantwortlich ist. Demgegenüber zeigt das Oszillogramm der **Fig. 3** Signalverläufe bei Anwendung eines vergleichbaren Beispiels zur

Erfindung, nämlich zunächst den Verlauf des von der Ansteuerschaltung 4 abgegebenen Ansteuersignals $s_{ast}$, das durch das oben erwähnte Einschaltsignal ausgelöst wird. Im vorliegenden Beispiel enthält das Ansteuersignal $s_{ast}$ n=10 Einschaltimpulse kurzer Dauer, nämlich jeweils ca. 5 μs, die in einem zeitlichen Abstand von etwa 33 μs aufeinanderfolgen. Nach dem zehnten Einschaltimpuls bleibt dann das Ansteuersignal $s_{ast}$ in

seinem EIN-Zustand von hier ca. 5 Volt.

Das Ergebnis dieser Ansteuerung spiegelt sich im Verlauf von Eingangsstrom $I_E$ und Eingangsspannung $U_E$ der Last 2 wider. Mit einer Verzögerung von ca. 200 $\mu$s bezogen auf den ersten Einschaltimpuls des Ansteuersignals $s_{ast}$ beginnen Strom und Spannung zu steigen, jedoch in einem "sanften" Verlauf, wobei der Spitzenwert des Stroms hier lediglich bei etwa 15 Ampere liegt, verglichen mit den 40 A der Fig. 1, obwohl es sich in beiden Fällen um die gleiche Last handelt.

Es wurde erfindungsgemäß gefunden, dass man die erwähnte Verzögerung, deren Ursache vor allem in induktiven Anteilen im Lastzweig liegt, weitgehend vermeiden kann, wenn man, wie dies **Fig. 4** zeigt, ein Ansteuersignals $s_{ast}$ verwendet, bei welchem die Dauer des ersten der Einschaltimpulse ein Mehrfaches der Dauer der folgenden Einschaltimpulse beträgt. Bei dem Beispiel der Fig. 4 beträgt die Dauer des ersten von zehn Einschaltimpulsen etwa 25 $\mu$s, wogegen die Dauer der folgenden, sehr kurzen Einschaltimpulse im Bereich von 2 $\mu$s liegt. In einem Vergleich mit Fig. 4 erkennt man, dass Strom und Spannung nun mit einer nur geringen Verzögerung von etwa 20 $\mu$s zu steigen beginnen und der Stromanstieg noch sanfter verläuft. De facto liegt keine "Spitze" mehr vor und das Maximum des Einschaltstroms beträgt ca. 8 A.

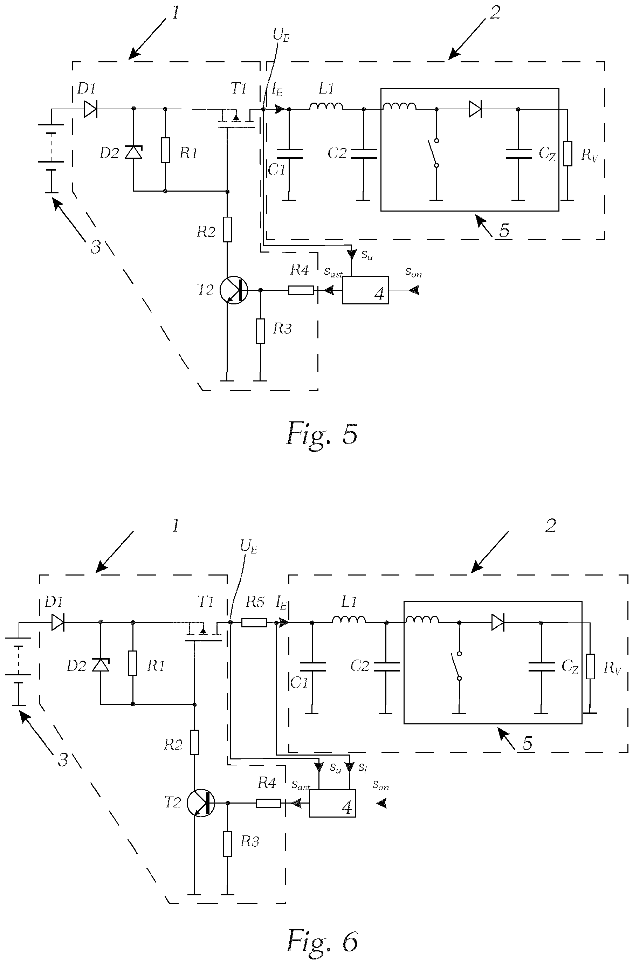

In **Fig. 5** ist eine Schaltungsanordnung dargestellt, die weitgehend jener der Fig. 1 entspricht. Die Last 2 mit hohem kapazitiven Anteil ist hier lediglich als Block gezeichnet, da ein Beispiel für eine solche Last bereits in Zusammenhang mit Fig. 3 gegeben wurde. Bei der gegenständlichen Ausführungsform wird der Ansteuerschaltung 4 ein mit der Eingangsspannung $U_E$ der Last 2 korreliertes Signal $\mathbf{s_U}$ zugeführt, d.h. entweder die Spannung $U_E$ direkt oder ein dieser Spannung proportionaler Wert. In diesem Fall ist die Ansteuerschaltung 4 für den elektronischen Eingangsschalter 1 dazu eingerichtet, solange zu schließen und zu öffnen, bis eine Solleingangsspannung der Last 2 erreicht ist. Danach gehen die Impulse in ein EIN-Signal über. Ebenso wie bei der Schaltung nach Fig. 1 umfasst der elektronischen Eingangsschalter 1 den eigentlichen (Schalt)transistor T1 und die zugehörigen, bereits weiter oben beschriebenen Bauelemente, wie insbesondere den Transistor T2.

Eine andere, auf einer Strommessung beruhende Variante der erfindungsgemäßen Schaltung ist in **Fig. 6** gezeigt, die gleichfalls weitgehend jener der Fig. 1 entspricht. Bei dieser Variante ist der Ansteuerschaltung 4 ein mit dem Eingangsstrom $I_E$ der Last 2 korreliertes Signal $\mathbf{s_I}$ zugeführt und die Ansteuerschaltung 4 für den elektronischen Eingangsschalter 1 ist dazu eingerichtet, bei Erhalt des Einschaltsignals $s_{on}$ ein Ansteuersignal $s_{ast}$ an den elektronischen Eingangsschalter 1 zu liefern, um diesen solange zu schließen und zu öffnen, bis ein Sollbetriebsstrom der Last 2 erreicht ist. Bei dem in Fig. 6 gezeigten Beispiel entspricht das mit dem Eingangsstrom $I_E$ der Last 2 korrelierte Signal $s_I$ dem Spannungsabfall, der an einem von dem Eingangsstrom $I_E$ der Last 2 durchflossenen Widerstand **R5** auftritt. Es sollte klar sein, dass auch andere Möglichkeiten zur Gewinnung des mit dem Eingangsstrom $I_E$ der Last 2 korrelierten Signals $s_I$, insbesondere ein Stromwandler, in Frage kommen. Auch hier umfasst der elektronische Eingangsschalter 1 den eigentlichen (Schalt)transistor T1 und die zugehörigen, bereits weiter oben beschriebenen Bauelemente, wie insbesondere den Transistor T2.

Der Unterschied zwischen den Beispielen der Fig. 1, 5 und 6 liegt darin, dass bei der Schaltung nach Fig. 1 die Ansteuerschaltung 4 eine vorbestimmte, selbstverständlich vorgebbare bzw. programmierbare Anzahl von Impulsen als Ansteuersignal $s_{ast}$ abgibt, wobei die Anzahl der Impulse den Anlaufzeitraum $t_{an}$ festlegt, wogegen bei der Schaltung nach Fig. 5 zwar gleichfalls Impulse als Ansteuersignal $s_{ast}$ abgegeben werden, die Impulse jedoch in ein EIN-Signal übergehen, sobald am Eingang der Last 2 eine Sollspannung $U_{soll}$ bzw. ein Sollstrom $I_{soll}$ erreicht sind. Der Anlaufzeitraum $t_{an}$ endet hier, sobald eine Sollspannung bzw. ein Sollstrom erreicht ist.

Es soll für den Fachmann klar sein, dass zur Realisierung der Ansteuerschaltung 4 bevorzugt ein programmierbarer Mikrocontroller zum Einsatz kommen kann. Gegebenenfalls könnte die Ansteuerschaltung 4 auch mit diskreten Bauelementen aufgebaut sein, doch bietet ein Mikrocontroller eine hohe Flexibilität zur Anpassung an unterschiedliche Lasten, Spannungen, Ströme und Einschaltzeiten, vor allem in im Falle von hinsichtlich ihrer Dauer unterschiedlicher Impulse des Ansteuersignals $s_{ast}$.

Die gezeigte Realisierung des elektronischen Eingangsschalters 1 ist selbstverständlich nur eine beispielsweise Ausführung, die sich jedoch in der Praxis aufgrund ihres einfachen und kostengünstigen Aufbaus bewährt hat, doch können andere angesteuerte Schalter als Eingangsschalter 1 zum Einsatz kommen.

**Patentansprüche**

1. Schaltungsanordnung zur Steuerung eines elektronischen Eingangsschalters (1), mit welchem eine Last (2) mit hohem kapazitiven Anteil an eine Kraftfahrzeugbatterie (3) schaltbar ist, wobei dem Eingang einer Ansteuerschaltung (4) für den elektronischen Eingangsschalter ein Einschaltsignal ($s_{on}$) zugeführt ist, die Ansteuerschaltung (4) für den elektronischen Eingangsschalter (1) dazu eingerichtet ist, bei Erhalt des Einschaltsignals ($s_{on}$) den elektronischen Eingangsschalter zunächst über einen Anlaufzeitraum ($t_{an}$) mit einer Anzahl (n) von Einschaltimpulsen getaktet zu schließen und zu öffnen und anschließend dauernd zu schließen, solange das Einschaltsignal ($s_{on}$) an dem Eingang der Ansteuerschaltung (4) anliegt, **dadurch gekennzeichnet, dass** die Dauer des ersten der Einschaltimpulse ein Mehrfaches der Dauer der folgenden Einschaltimpulse beträgt.

2. Schaltungsanordnung nach Anspruch 1, **dadurch gekennzeichnet, dass** der elektronische Eingangsschalter einen von einem Bipolartransistor (T2) angesteuerten FET-Transistor (T1) umfasst, wobei dem Bipolartransistor ein Ausgangssignal der Ansteuerschaltung (4) zugeführt ist.

3. Schaltungsanordnung nach Anspruch 2, **dadurch gekennzeichnet, dass** der Ansteuerschaltung (4) ein mit der Eingangsspannung ($U_E$) der Last (2) korreliertes Signal (su) zugeführt ist und die Ansteuerschaltung (4) für den elektronischen Eingangsschalter (1) dazu eingerichtet ist, solange zu schließen und zu öffnen, bis eine Solleingangsspannung der Last (2) erreicht ist.

4. Schaltungsanordnung nach einem der vorhergehenden Ansprüche, **dadurch gekennzeichnet, dass** der Ansteuerschaltung (4) ein mit dem Eingangsstrom ($I_E$) der Last (2) korreliertes Signal ($s_I$) zugeführt ist und die Ansteuerschaltung (4) für den elektronischen Eingangsschalter (1) dazu eingerichtet ist, solange zu schließen und zu öffnen, bis ein Sollbetriebsstrom der Last (2) erreicht ist.

5. Schaltungsanordnung nach einem der vorhergehenden Ansprüche, **dadurch gekennzeichnet, dass** die Last (2) ein Hochsetzsteller (5) ist.

**Claims**

1. Circuit arrangement for controlling an electronic input switch (1), with which which a load (2) with a high capacitive component can be connected to a motor vehicle battery (3), the input of a drive circuit (4) for the electronic input switch being supplied with a switch-on signal (Son), the drive circuit (4) for the electronic input switch (1) being set up for this purpose, on receipt of the switch-on signal (Son), to initially close and open the electronic input switch in a clocked manner over a start-up period (ton) with a number (n) of switch-on pulses and then to close it continuously as long as the switch-on signal (Son) is present at the input of the drive circuit (4), **characterized in that** the duration of the first of the switch-on pulses is a multiple of the duration of the following switch-on pulses.

2. Circuit arrangement according to claim 1, **characterized in that** the electronic input switch comprises an FET transistor (T1) driven by a bipolar transistor (T2), an output signal of the drive circuit (4) being supplied to the bipolar transistor.

3. Circuit arrangement according to claim 2, **charac-**

**terized in that** the drive circuit (4) is supplied with a signal (su) correlated with the input voltage (UE) of the load (2), and the drive circuit (4) for the electronic input switch (1) is set up to close and open until a set input voltage of the load (2) is reached.

4. Circuit arrangement according to one of the preceding claims, **characterized in that** a signal (si) correlated with the input current (IE) of the load (2) is fed to the drive circuit (4), and the drive circuit (4) for the electronic input switch (1) is set up to close and open until a setpoint operating current of the load (2) is reached.

5. Circuit arrangement according to one of the preceding claims, **characterized in that** the load (2) is a step-up divider (5).

**Revendications**

1. Circuit pour la commande d'un commutateur d'entrée électronique (1), avec lequel dans lequel une charge (2) avec une composante capacitive élevée peut être connectée à une batterie de véhicule à moteur (3) dans lequel un signal de mise en marche (Son) est fourni à l'entrée d'un circuit de commande (4) pour le commutateur d'entrée électronique, le circuit de commande (4) pour le commutateur d'entrée électronique (1) est configuré pour à la réception du signal de mise en marche (Son), le commutateur d'entrée électronique est d'abord fermé et ouvert de manière cadencée pendant une période de démarrage (ton) avec un nombre (n) d'impulsions de mise en marche et est ensuite fermé en continu tant que le signal de mise en marche (Son) est présent à l'entrée du circuit d'entraînement (4), **caractérisé en ce que** la durée de la première des impulsions de mise en marche est un multiple de la durée des impulsions de mise en marche suivantes.

2. Circuit selon la revendication 1, **caractérisé en ce que** le commutateur d'entrée électronique comprend un transistor FET (T1) piloté par un transistor bipolaire (T2), un signal de sortie du circuit de commande (4) étant fourni au transistor bipolaire.

3. Circuit selon la revendication 2, **caractérisé en ce qu'**un signal (su) corrélé à la tension d'entrée (UE) de la charge (2) est amené au circuit de commande (4), et le circuit de commande (4) pour le commutateur d'entrée électronique (1) est réglé pour se fermer et s'ouvrir jusqu'à ce qu'une tension d'entrée réglée de la charge (2) soit atteinte.

4. Circuit selon l'une des revendications précédentes, **caractérisé en ce qu'**un signal (si) corrélé au courant d'entrée (IE) de la charge (2) est fourni au circuit de commande (4) et le circuit de commande (4) pour le commutateur d'entrée électronique (1) est réglé pour se fermer et s'ouvrir jusqu'à ce qu'un courant de fonctionnement de consigne de la charge (2) soit atteint.

5. Circuit selon l'une des revendications précédentes, **caractérisé en ce que** la charge (2) est un diviseur élévateur (5).

*Fig. 1*

*Fig. 2*

*Fig. 3*

*Fig. 4*

Fig. 5

Fig. 6

9

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2015303917 A1
- WO 2012097866 A1
- EP 2259422 A1
- WO 2012087320 A1
- EP 2388917 A2
- EP 2688209 A1
- WO 2015037441 A1